# EUROPÄISCHE PATENTSCHRIFT

(11) **EP 1 676 201 B1**
(45) Veröffentlichungstag und Bekanntmachung des Hinweises auf die Patenterteilung: **16.01.2008**
(21) Anmeldenummer: 04762463.0
(22) Anmeldetag: 22.07.2004
(51) Int. Cl.: G06F 11/16

(54) **STEUERGERÄT**
CONTROL DEVICE
APPAREIL DE COMMANDE

(30) Priorität: 13.10.2003 DE 10347413
(43) Veröffentlichungstag der Anmeldung: 05.07.2006
(73) Patentinhaber: ROBERT BOSCH GMBH, 70442 Stuttgart (DE)
(72) Erfinder: MATTES, Bernhard, 74343 Sachsenheim (DE); MALICKI, Siegfried, 74379 Ingersheim (DE)
(86) Internationale Anmeldenummer: PCT/DE2004/001613
(87) Internationale Veröffentlichungsnummer: WO 2005/045674

(56) Entgegenhaltungen:
- WO-A-95/21412
- US-A- 4 282 493

## Beschreibung

### Stand der Technik

Die Erfindung geht aus von einem Steuergerät nach der Gattung des unabhängigen Patentanspruchs.

Aus DE 101 23 839 A1 ist es bekannt in einem Steuergerät zwischen einem Prozessor und wenigstens einer weiteren Schaltung insbesondere ASIC's eine Datenübertragung hier über SPI (Serial Peripheral Interface) vorzusehen, die getaktet ist. Der Prozessor gibt den Takt an die ASIC's aus. Der Prozessor leitet den Takt von der Oszillation eines System-Oszillators, beispielsweise eines Pierce-Oszillators, ab.

Aus US 4,282,493 ist es bekannt, zwei Taktmodule vorzusehen, die jeweils zwei PLL-Oszillatoren aufweisen. Einer der PLL-Oszillatoren wird verwendet, um ein Takt- und Referenzsignal am Ausgang des Taktmoduls bereitzustellen, während der andere PLL-Oszillator dazu verwendet wird, sowohl die Phase und Frequenz des ersten Oszillators zu überwachen. Aus WO 95/21412 A1 ist es bekannt, einen Systemtakt für einen Microcontroller und einen Prozessor in einem Bremssystem zu erzeugen. Der Systemtakt wird durch einen Oszillator erzeugt, der mit dem Microcontroller verbunden ist. Eine Überwachungsschaltung für die Taktfrequenz ist vorgesehen, die die Taktfrequenz auf Grenzunter- bzw. -überschreitungen überwacht.

### Vorteile der Erfindung

Das erfindungsgemäße Steuergerät mit den Merkmalen des unabhängigen Patentanspruchs hat demgegenüber den Vorteil, dass nunmehr der Prozessor im Steuergerät, vorzugsweise ein Microcontroller, anhand von Ausgangssignalen von wenigstens zwei Taktausgängen des Prozessors den Takt überwacht. Diese Überwachung kann hardwaremäßig und/oder softwaremäßig erfolgen. In Abhängigkeit von der Überwachung wird ein Überwachungssignal erzeugt, das dazu benutzt werden kann, um einen Fehlerspeicher zu beschreiben und/oder eine Warnung auszugeben, beispielsweise mittels einer Warnlampe. Aber auch auf einem Display im Fahrzeug kann der entsprechende Fehler ausgegeben werden. Es ist sogar möglich, dass das Überwachungssignal dazu benutzt wird, um eine Funkübertragung zu einer Fernwartung zu übertragen, so dass der Fehler der Fernwartung mitgeteilt wird und diese den Fahrer benachrichtigen kann, um eine entsprechende Reparatur durchführen zu lassen. Es ist möglich, dass mehr als zwei Taktausgänge und damit die entsprechenden Ausgangssignale zu Überwachung des Takts verwendet werden. Damit erhält man eine hohe Sicherheit gegenüber Fehlern des Taktsignals, die Fehlfunktionen des Airbagsteuergeräts provozieren können.

Durch die in den abhängigen Ansprüchen aufgeführten Maßnahmen und Weiterbildungen sind vorteilhafte Verbesserungen des im unabhängigen Patentanspruch angegebenen Steuergeräts möglich.

Besonders vorteilhaft ist, dass die Taktausgänge derart beschaltet sind, dass das Steuergerät in Abhängigkeit von den Ausgangssignalen aus den Taktausgängen ein Überwachungssignal erzeugt. Vorzugsweise wird die Beschaltung derart gestaltet, dass die Ausgänge auf einen Exklusiv-Oder-Baustein führen, so dass, wenn ein Taktausgang mit dem anderen Taktausgang nicht mehr bezüglich seines Ausgangssignals übereinstimmt es zu einem Ausgangssignal des Exklusiv-Oder-Bausteins kommt und so einen Fehler anzeigt. Dies ist eine besonders einfache und zuverlässige Hardwareschaltung zur Fehleranzeige.

Weiterhin ist es vorteilhaft, dass die Taktausgänge an Eingänge des Prozessors zurückgeführt werden, so dass der Prozessor selbst die Ausgangssignale der Taktausgänge überwachen kann. Beispielsweise kann er so eine amplitudenmäßige Überwachung durchführen und auch die Exklusiv-Oder-Funktion softwaretechnisch nachbilden. Die getrennte Überwachung der Ausgangssignale ermöglicht, dass bei einer entsprechend redundanten Auslegung des Systemstakts das Steuergerät weiter arbeiten kann, auch wenn ein Ausgangssignal nicht mehr den Anforderungen entspricht.

Dabei ist es nämlich vorgesehen, dass die wenigstens zwei Ausgangssignale der beiden Taktausgänge zusammen den Takt für die weiteren Schaltungen erzeugen. Dies wird am einfachsten durch eine Veroderung der beiden Taktausgangssignale erreicht. Die Veroderung kann vorzugsweise dadurch erreicht werden, dass jeweils eine Diode in Flussrichtung an die beiden Taktausgänge geschaltet wird. Die Dioden sind dann auf der anderen Seite miteinander verknüpft, so dass eine Veroderung stattfindet. Das so erzeugte Taktsignal kann dann durch einen Impedanzwandler und/oder einen Verstärker weiter verarbeitet werden, wobei der Impedanzwandler dafür vorgesehen ist, um die Belastung der Taktsignale zu minimieren und der Verstärker dazu vorgesehen ist, das Taktsignal entsprechend zu verstärken.

Es wird weiterhin vorteilhaft, dass die beiden Taktausgänge jeweils anderen Portgruppen zugeordnet sind, wie auch die beiden Eingänge, die zur Überwachung der Ausgangssignale der Taktausgänge vorgesehen sind. Diese Trennung zu verschiedenen Portgruppen bedeutet einen vergrößerten Abstand der Schaltungsgruppen auf dem Chip, so dass bei einer Hardwarebeschädigung eines Ausgangs oder Eingangs der andere Ausgang bzw. Eingang nicht mitbeeinträchtigt wird. Dies erhöht die Sicherheit des Systems.

### Zeichnung

Ein Ausführungsbeispiel der Erfindung ist in der Zeichnung dargestellt und wird in der nachfolgenden Beschreibung näher erläutert.

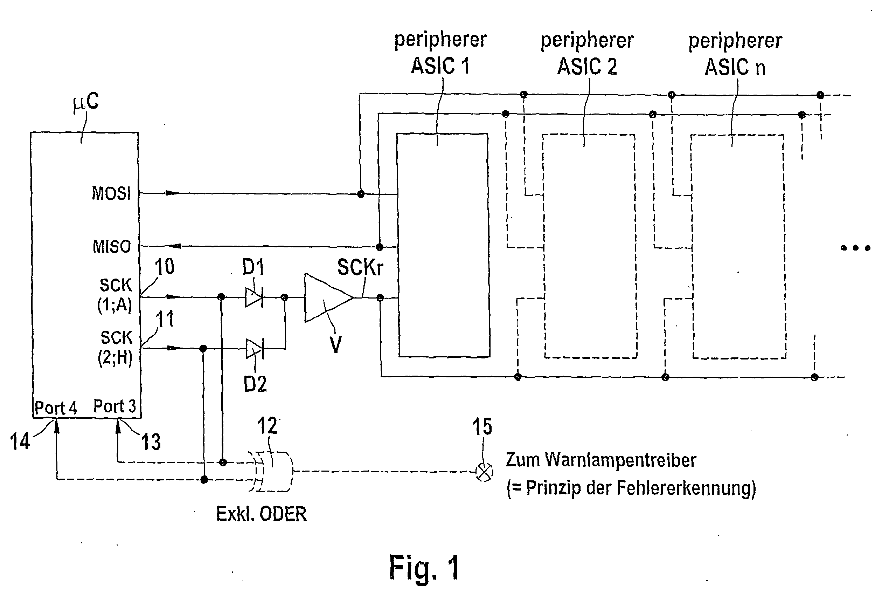

Es zeigt
Figur 1 ein Blockschaltbild des erfindungsgemäßen Steuergeräts.

### Beschreibung

Steuergeräte, insbesondere zur Ansteuerung von Personenschutzmitteln wie Airbags, Gurtstraffer oder Überrollbügel müssen eine hohe Zuverlässigkeit aufweisen, so dass es vermieden wird, dass interne Fehlfunktionen zu unerwünschten Situationen für Fahrzeuginsassen führen. Häufig wird zur Datenübertragung zwischen dem Microcontroller im Steuergerät und den angeschlossenen Bausteinen im Steuergerät den sogenannten ASIC's, wie einer Zündkreisansteuerung oder den Sensoren oder Schnittstellenbausteinen, das SPI (Serial Peripheral Interface) verwendet. Dabei wird eine Leitung MOSI (Master Out Slave In) dazu verwendet, dass derMicrocontroller Daten zu den angeschlossenen Bausteinen überträgt und eine weitere Leitung MISO (Master In Slave Out) dazu verwendet wird, dass die angeschlossenen ASIC's an den Microcontroller Daten übertragen können. Dabei handelt es sich um getrennte Leitungen. Es gibt noch weitere Leitungen des Serial Peripherial Interface, wie Chip-Select und auch die Taktleitung. Es handelt sich hierbei wirklich um getrennte Hardwareleitungen. Der µC-Controller versorgt über die Taktleitungen die angeschlossenen ASIC's mit diesen Takt, so dass es zu einer synchronen Datenübertragung kommt. Nunmehr ist klar, dass bei einem Fehler des Taktsignals es zu Fehlern in der Funktion des Steuergeräts kommen kann.

Erfindungsgemäß wird daher das Taktsignal anhand von den Ausgangssignalen von zwei Taktausgängen des Microcontrollers, der auch ein anderer Prozessor sein kann, überwacht. Diese Überwachung kann hardware- oder softwaremäßig durchgeführt werden. Als hardwaremäßige Realisierung bietet sich beispielsweise die Verwendung eines Exklusiv-Oder- oder Antivalenz-Bausteins an, während bei der softwaremäßigen Überwachung der Microcontroller selbst wieder zum Einsatz kommt, in dem die Ausgangssignale der Taktausgänge wieder auf Eingänge des Microcontrollers zurückgeführt werden. Die softwaremäßige Realisierung hat den Vorteil, dass die einzelnen Ausgangssignale getrennt überwacht werden können. Zusätzlich kann bei der Verwendung von zwei Taktausgängen eine höhere Redundanz bei der Erzeugung des Takts erzielt werden, indem die Ausgänge, die das Taktsignal liefern miteinander vorzugsweise verodert werden.

Figur 1 zeigt ein Blockschaltbild des erfindungsgemäßen Steuergeräts. Das Blockschaltbild konzentriert sich nur auf die wesentlichen Elemente der Erfindung, so dass andere Komponenten, die sich auch im Steuergerät befinden, der Einfachheit halber nicht dargestellt sind. Ein Microcontroller µC ist über einen Datenausgang MOSI mit im Steuergerät befindlichen ASIC's 1, 2 und n verbunden. Die Leitung MOSI wird zur Datenübertragung vom µC zu den ASIC's 1, 2 und n verwendet. Über einen Dateneingang ist der Microcontroller µC ebenfalls mit den ASIC's 1, 2 und n verbunden, wobei aber hier die Leitungen MISO zur Datenübertragung der ASIC's zum Microcontroller genutzt wird. Die Datenübertragung zwischen dem Microcontroller und den ASIC's 1, 2 und n kann quasi parallel ablaufen. Über einen weiteren Ausgang 10 und 11 werden Taktsignale des Microcontrollers µC ausgegeben, die der Microcontroller µC durch Teilung eines Oszillatorsignals erzeugt hat. Als Oszillator kommt hier beispielsweise ein Pierce-Oszillator in Frage, der leicht anschwingt und ein stabiles Taktsignal liefert. Die Taktausgänge 10 und 11 führen jeweils zu Dioden D1 und D2, die selbst auch zusammengeführt auf einen Eingang eines Verstärkers V gehen. Der Verstärker V liefert dann den Takt SCKr. Dieser Takt geht dann an die Bausteine ASIC 1, ASIC 2 und ASIC n. Damit laufen dann in ihrer Verarbeitung der Microcontroller µC und die ASIC's 1, 2 bis n parallel.

Die Ausgangssignale der Taktausgänge 10 und 11 werden jedoch auch jeweils an Eingänge eines Exklusiv-Oder-Bausteins geführt. Der Exklusiv-Oder-Baustein zeigt ein Signal an seinem Ausgang, wenn die beiden Eingangssignale unterschiedlich sind. D. h., nur bei einer 0 und 1 bzw. 1 und 0 liefert das Exklusiv-Oder-Baustein eine 1, ansonsten eine 0. In Abhängigkeit von diesem Ausgangssignal des Exklusiv-Oder-Bausteins 12 wird ein Wamlampentreiber 15 angesteuert, der im Fehlerfall also wenn die beiden Taktsignale unterschiedlich sind, eine Warnlampe ansteuert, um einen Fehler anzuzeigen.

Alternativ oder zusätzlich ist es möglich, dass der Microcontroller µC selbst die Ausgangssignale der Taktausgänge 10 und 11 überwacht. Dazu werden die Ausgangssignale auf zwei Eingänge 13 und 14 jeweils zurückgeführt. Der Microcontroller µC kann dann softwaremäßig die Ausgangssignale überwachen. Dies kann er beispielsweise dadurch tun, dass er die Exklusiv-Oder-Funktion softwaretechnisch nachbildet und dass er die Ausgangssignale getrennt amplitudenmäßig überwacht. Der Microcontroller µC erzeugt dann in Abhängigkeit davon ein Überwachungssignal, das zur Ansteuerung beispielsweise des Warnlampentreibers verwendet wird. Eine Warnung kann jedoch auch auf einem Display im Fahrzeug angezeigt werden. Die Eingänge 3 und 4 sollten verschiedenen Portgruppen zugeordnet werden. Unter Portgruppe werden hier benachbarte Ein- bzw. Ausgänge verstanden. Auch die Taktausgänge 10 und 11 sollten unterschiedlichen Portgruppen zugehörig sein, damit sie geographisch nicht benachbart sind, um bei einem Hardwarefehler einen Ausfall der beiden Taktausgänge zu vermeiden.

Anstatt der SPI-Kommunikation, die eine Buskommunikation ist, können auch Punkt-zu-Punkt-Verbindungen zwischen dem Microcontroller µC und den einzelnen ASICs jeweils eingesetzt werden. Doch auch andere Busverbindungen alternativ zur SPI-Verbindung sind möglich.

## Patentansprüche

1. Steuergerät mit einer getakteten Datenübertragung zwischen einem Prozessor (µC) und wenigstens einer weiteren Schaltung (ASIC 1, 2, n), wobei der Prozessor (µC) einen Takt (SCKr) ausgibt, **dadurch gekennzeichnet, dass** der Prozessor (µC) derart konfiguriert ist, dass der Prozessor (µC) den Takt (SCKr) anhand von Ausgangssignalen wenigstens zweier Taktausgänge (10, 11) des Prozessors (µC) überwacht, dass die wenigstens zwei Taktausgänge (10, 11) derart beschaltet sind, dass der Takt (SCKr) in Abhängigkeit von den Ausgangssignalen erzeugt wird, wobei der Prozessor (µC) die Ausgangssignale durch Teilung eines Oszillatorsignals erzeugt hat.

2. Steuergerät nach Anspruch 1, **dadurch gekennzeichnet, dass** die wenigstens zwei Taktausgänge (10, 11) derart beschaltet sind, dass das Steuergerät in Abhängigkeit von den Ausgangssignalen ein Überwachungssignal erzeugt.

3. Steuergerät nach Anspruch 2, **dadurch gekennzeichnet, dass** ein Exklusiv-Oder-Baustein (12) vorgesehen ist, dem die Ausgangssignale jeweils zugeführt werden, wobei in Abhängigkeit von einem Signal des Exklusiv-Oder-Bausteins (12) das Überwachungssignal erzeugt wird.

4. Steuergerät nach Anspruch 1, **dadurch gekennzeichnet, dass** die wenigstens zwei Taktausgänge (10, 11) derart beschaltet sind, dass die Ausgangssignale jeweils an einen ersten und einen zweiten Eingang (13, 14) des Prozessors (µC) zurückgeführt werden, so dass der Prozessor (µC) die Ausgangssignale überwacht und in Abhängigkeit davon das Überwachungssignal erzeugt.

5. Steuergerät nach Anspruch 1, **dadurch gekennzeichnet, dass** die wenigstens zwei Taktausgänge (10, 11) miteinander verodert zur Bildung des Takts vorgesehen sind.

6. Steuergerät nach Anspruch 5, **dadurch gekennzeichnet, dass** für die Veroderung für die wenigstens zwei Taktausgänge (10, 11) jeweils eine Diode (D1, D2) oder ein ODER-Gatter vorgesehen sind.

7. Steuergerät nach Anspruch 5 oder 6, **dadurch gekennzeichnet, dass** der Takt (SCKr) einen Impedanzwandler und/oder einen Verstärker (V) zugeführt werden.

8. Steuergerät nach einem der vorhergehenden Ansprüche, **dadurch gekennzeichnet, dass** die Taktausgänge (10, 11) verschiedenen Portgruppen zugeordnet sind.

9. Steuergerät nach einem der Ansprüche 4 bis 8, **dadurch gekennzeichnet, dass** der erste und der zweite Eingang (13, 14) verschiedenen Portgruppen zugeordnet sind.

## Claims

1. Control device having clocked data transmission between a processor (µC) and at least one further circuit (ASIC 1, 2, n), the processor (µC) outputting a clock (SCKr), **characterized in that** the processor (µC) is configured in such a manner that the processor (µC) monitors the clock (SCKr) using output signals from at least two clock outputs (10, 11) of the processor (µC), **in that** the at least two clock outputs (10, 11) are connected in such a manner that the clock (SCKr) is generated on the basis of the output signals, the processor (µC) having generated the output signals by dividing an oscillator signal.

2. Control device according to Claim 1, **characterized in that** the at least two clock outputs (10, 11) are connected in such a manner that the control device generates a monitoring signal on the basis of the output signals.

3. Control device according to Claim 2, **characterized in that** an exclusive OR module (12) which is respectively supplied with the output signals is provided, the monitoring signal being generated on the basis of a signal from the exclusive OR module (12).

4. Control device according to Claim 1, **characterized in that** the at least two clock outputs (10, 11) are connected in such a manner that the output signals are respectively fed back to a first and a second input (13, 14) of the processor (µC), with the result that the processor (µC) monitors the output signals and generates the monitoring signal on the basis of the latter.

5. Control device according to Claim 1, **characterized in that** the at least two clock outputs (10, 11) are ORed in order to form the clock.

6. Control device according to Claim 5, **characterized in that** a diode (D1, D2) or an OR gate is respectively provided for ORing the at least two clock outputs (10, 11).

7. Control device according to Claim 5 or 6, **characterized in that** the clock (SCKr) is supplied to an impedance converter and/or an amplifier (V).

8. Control device according to one of the preceding claims, **characterized in that** the clock outputs (10, 11) are assigned to different port groups.

9. Control device according to one of Claims 4 to 8, **characterized in that** the first and second inputs (13, 14) are assigned to different port groups.

## Revendications

1. Appareil de commande avec une transmission de données cadencée entre un processeur (µC) et au moins un autre circuit (ASIC 1, 2, n), le processeur (µC) émettant une cadence (SCKr),
**caractérisé en ce que**
le processeur (µC) est configuré pour surveiller la cadence (SCKr) à l'aide des signaux de sortie d'au moins deux sorties de cadence (10, 11) du processeur (µC), et
au moins deux sorties de cadence (10, 11) sont branchées pour générer la cadence (SCKr) en fonction des signaux de sortie,
le processeur (µC) générant les signaux de sortie par division d'un signal d'oscillateur.

2. Appareil de commande selon la revendication 1,
**caractérisé en ce qu'**
au moins deux sorties de cadence (10, 11) sont branchées pour que l'appareil de commande génère un signal de surveillance en fonction des signaux de sortie.

3. Appareil de commande selon la revendication 2,
**caractérisé par**
un composant ou-exclusif (12) recevant les signaux de sortie, et en fonction d'un signal du composant ou-exclusif (12) on génère le signal de surveillance.

4. Appareil de commande selon la revendication 1,
**caractérisé en ce qu'**
au moins deux sorties de cadence (10, 11) sont branchées pour que les signaux de sortie soient appliqués à une première et une seconde entrées (13,14) du processeur (µC) pour qu'il surveille les signaux de sortie et génère le signal de surveillance en fonction de cela.

5. Appareil de commande selon la revendication 1,
**caractérisé en ce qu'**
au moins les deux sorties de cadence (10, 11) sont reliées de manière ordonnée pour former la cadence.

6. Appareil de commande selon la revendication 5,
**caractérisé en ce que**
la liaison ordonnée au moins des deux sorties de cadence (10, 11) se fait par une diode (D1, D2) ou une porte.

7. Appareil de commande selon les revendications 5 ou 6,
**caractérisé en ce que**
la cadence (SCKr) est appliquée à un convertisseur d'impédance et/ ou un amplificateur (V).

8. Appareil de commande selon l'une des revendications précédentes,
**caractérisé en ce que**
les sorties de cadence (10, 11) sont associées à différents groupes de ports.

9. Appareil de commande selon l'une des revendications 4 à 8,
**caractérisé en ce qu'**
une première et une seconde entrée (13, 14) sont associées à différents groupes de ports.
